Europäisches Patentamt

European Patent Office

Office européen des brevets

Publication number: **0 489 349 A1**

# EUROPEAN PATENT APPLICATION

Application number: **91120303.2**

Date of filing: **27.11.91**

Int. Cl.⁵: **H01L 21/56**

Priority: **27.11.90 US 619107**

Date of publication of application:
**10.06.92 Bulletin 92/24**

Designated Contracting States:
**DE ES FR GB IT**

Applicant: **LSI LOGIC CORPORATION**
**1551 McCarthy Boulevard**
**Milpitas, CA 95035(US)**

Inventor: **Schneider, Mark R.**
**6948 Villagewood Way**
**San Jose, CA 95120(US)**
Inventor: **Fehr, Gerald K.**
**10196 English Oak Way**
**Cupertino CA 95014(US)**

Representative: **Kahler, Kurt, Dipl.-Ing.**
**Postfach 1249 Gerberstrasse 3**
**W-8948 Mindelheim(DE)**

## Molding process for plastic IC packages.

There is disclosed a molding process for plastic IC packages, wherein each of the top and bottom mold halves (302,304) of a mold set (300) are provided with gates (316,326) for injecting liquid molding compound into a cavity (310) formed by the two mold halves (302,304). In this manner, forces exerted by the liquid molding compound are equalized above and below the plane of a die-supporting substrate (18) for forming a body about the semiconductor die (22). During injection of the molding compound the substrate (18) is supported by the peripheral portions of the mold halves (302,304) to avoid desorientation of the die (22) and distortion of bond wires (24).

*FIG. 3*

EP 0 489 349 A1

## Technical Field Of The Invention

The invention relates to the packaging of semiconductor devices, and more particularly to the following types of plastic-packaged semiconductor devices: DIP (dual in-line package), PQFP (plastic quad flat pack) and PLCC (plastic leaded chip carrier) and the like.

## Background Of The Invention

Present plastic packaging techniques involve molding a plastic "body" around a semiconductor die. Prior to molding, the die is attached to a lead frame having a plurality of leads ultimately exiting the package for connecting the semiconductor device to external circuits, such as via conductors on a printed circuit board. Various forms of plastic packs are known, including DIP (Dual In-line Package), PQFP (Plastic Quad Flat Pack) and PLCC (plastic leaded chip carrier.

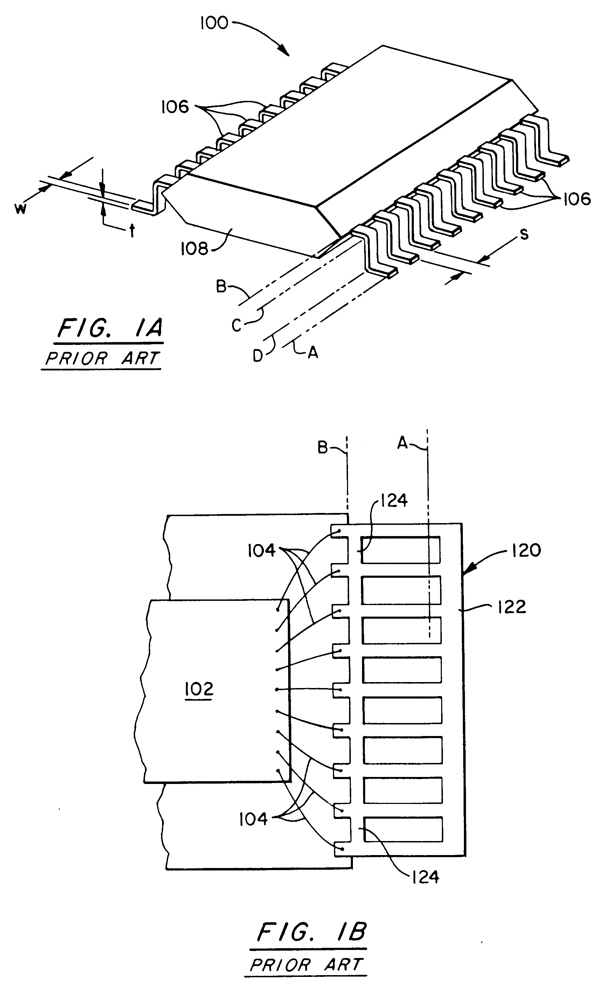

Figures 1A and 1B show a typical plastic-packaged semiconductor device 100 of the prior art. A semiconductor die 102 is connected, such as by a number of bond wires 104, to inner ends of a corresponding number of leads 106. Other techniques for connecting the die to the inner ends of the leads are known. A plastic body 108 is formed about the die 102 and the inner ends of the leads, by any of a number of known molding processes. The exposed outer portions of the leads 106, exterior the body 108, are bent downwardly (indicated by the dashed line "C") and outwardly (indicated by the dashed line "D") to form what is commonly termed a "gull wing" configuration. Each lead 106 has a width (w) on the order of six thousandths of an inch (0.2 mm), and the spacing (s) between adjacent leads 106 is typically on the order of fifteen thousandths of an inch (0.5 mm).

Figure 1B shows a lead form (or frame) 120 having a plurality of leads 106. The lead frame is formed from a conductive foil having a thickness (t) on the order of a few thousandths of an inch (e.g. 0.004-0.006 inch). The material for the leads 106 is typically copper, or "Alloy 42". As shown, the leads 106 terminate in an outer square ring portion 122 of the lead frame 120, from which the completed (packaged) device is ultimately excised, as indicated by the dashed line "A". Of particular note in Figure 1B are "dambars" 124 bridging adjacent leads 106 at a position indicated by the dashed line "B" (closely adjacent or immediately exterior to the body 108. The dambars 124 are formed from the conductive material forming the leads 106, and hence are of the same thickness as the leads 106. These dambars 124 aid in maintaining alignment between the inner ends of the leads, although a die attach pad (not shown) formed from the foil is typically employed and will serve the same purpose. More importantly, however, the dambars 124 are critical in the molding process, discussed hereinbelow. Since the leads 106 create a gap between the clamshell halves of the mold, the dambars 124 prevent plastic from "flashing" between the leads 106 exterior the body 108. After the die is packaged in the plastic body, the dambars 124 are excised, and any residual plastic flash between the outer portions of leads 106 is cleaned out in a "dejunking" step.

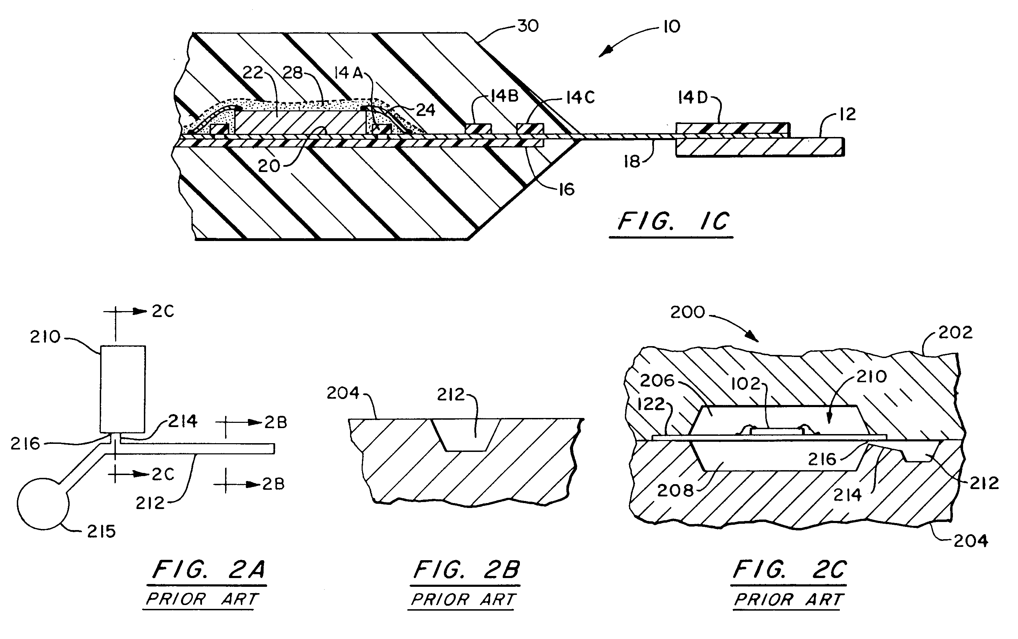

Figure 1C shows, generally, a tape-mounted semiconductor device assembly 10, as described in copending, commonly-owned U.S. Patent Application No. 454,752, entitled HEAT SINK FOR SEMICONDUCTOR DEVICE ASSEMBLY, filed December 19, 1989 by Long, Schneider and Patil. The semiconductor device assembly 10 includes an upper, segmented plastic film layer 14, formed of segments 14A, 14B, 14C and 14D , a lower plastic film layer 16, metallic leads 18 sandwiched between the two plastic layers 14 and 16, a metallic (preferably copper) die attach pad 20 supported between the two plastic layers 14 and 16, a semiconductor device 22 mounted on the die attach pad 20 and bond leads 24 connecting the semiconductor device 22 to the leads 18. In lieu of employing bond wires 24, conductive bumps may be employed to provide a conductive path from the device 22 to the leads 18 in a tape automated bonding (TAB) process.

The upper plastic layer 14 does not form a continuous surface, but rather is segmented to include an inner ring portion 14A, one or more intermediate ring portions 14B and 14C disposed outside of the inner ring portion, and an exterior ring portion 14D disposed outside of the intermediate ring portions. The upper plastic layer 14 is formed of a plastic tape, such as KAPTON, and forms a thin, insulating supportive structure for the leads 18. The inside periphery of the inner ring portion 14A supports the outside periphery of the die attach pad 20, and the outside periphery of the inner ring portion 14A supports the innermost ends of the leads 18, in essence forming a "bridge" between the die attach pad and the leads. A layer-like quantity of silicone gel 28, such as Dow Corning Q1-4939, having a 1 to 10 mixing ratio of curing agent to base, encapsulates the leads 24. A body 30, formed of molding compound (described hereinafter), is formed around the device 22, leaving outer portions of the leads 18 exposed, exterior the body. The silicone gel 28 acts as a moisture barrier and a stress relief for the leads 24 during body molding, as well as prevents molding compound from contacting the semiconductor die. Surface tension between the silicone gel and the leads 24 keeps the silicone gel in place around the leads during assembly of the semiconductor device assembly. The lower plastic layer 16 covers the bottom of the die attach pad 20, and extends generally over the entire area described by the intermediate ring portion 14C, on the opposite side of the leads 18 and die attach pad 20. The lower plastic layer 16 is formed of a plastic tape material, such as KAPTON.

A "surrogate" lead frame (edge ring) 12 is provided for handling the semiconductor device assembly during manufacture thereof, and shorts the outer ends of the leads 18 to facilitate electroplating. After molding the body about the device, the semiconductor device assembly is excised from the lead frame 12 and exterior ring portion 14D, neither of which properly form any part of the ultimate semiconductor device assembly 10.

Figures 2A, 2B and 2C show transfer molding apparatus of the prior art. Transfer molding is an automated version of compression molding in which hot, liquid molding compound is forced from a reservoir, or pot, into mold cavities (discussed below).

Molding compounds are typically resins, such as advanced B-stage compounds. In general purpose applications, wood-flour-filled phenolics, for instance, are fairly popular due to their excellent moldability and low cost. As powders and granules, they are also easily shaped into pellets by automatic preformers. The main drawback with phenolics is their limited colorability. When coloring is a major design factor, melamine, polyester, or urea are usually selected because there is a wider selection of shades and colors. For electronic packaging, the preferred resin is epoxy.

The mold set 200 has two halves, a top half 202 and a bottom half 204, each of which is provided with a recess 206 and 208, respectively. The recesses face each other when the mold is closed, forming a cavity 210 defining the size, shape and surface finish of a molded body (e.g., 108 of Figure 1A). As shown in Figure 2C, the mold halves close around the lead frame (e.g., 122 of Figure 1B; or surrogate lead frame 12 of Figure 1C), that close about open to receive lead frames and are closed (as shown), so that the semiconductor device (e.g., 102 of Figure 1B) is contained within the cavity 210.

The bottom half 204 of the mold set is typically provided with a primary "runner" 212 receiving molten molding compound from a pot 214. One or more secondary runners 214 extend from the primary runner 212 to the cavity 210, in the bottom half 204 of the mold set. At the interface between the secondary runner 214 and the cavity 208 is a "gate" 216. "Gates" are small openings into the cavity 210 where the liquid molding compound is injected, and are normally found only in the bottom mold half ("chase") under the plane of the chip and the wires to minimize wire sweep. Typical gate dimensions are 60-100 mils wide (at the cavity interface) by 20-30 mils deep (from the secondary runner to the cavity). Air vent slots (not shown) are located opposite each gate to prevent partial fill and voids in the finished part.

In the case of a molding press provided with multiple mold sets (hence, multiple cavities), the layout of the runner system is balanced to provide for an even distribution of molding compound to each cavity. The object is to fill each cavity with compound of uniform density so that parts located next to a pressurized input (not shown) will have identical properties to those located at the other locations along the primary runner.

It has been noted by the inventors hereof that the flow of molten compound (plastic) into the bottom mold half causes distortion of the die attach pad (e.g., 20, Figure 1C). Large die attach pads are forced upward in the process, destroying wire bonds or disorienting the die. The result is often reject parts, which represent waste and decreased throughput. Further, as lead count increases (lead pitch gets finer) each lead becomes increasingly more delicate, exacerbating the aforementioned problems.

These problems are particularly evident when the semiconductor device (die) is mounted to a tape, in what is termed a "tape automated bonding" (TAB) process (See e.g., Figure 1C). Because the supporting TAB structure (e.g., 14, 16, 18, Figure 1C) is flimsier than lead frame counterparts (e.g., 122, Figure 1B), extra care in handling during the molding process is required. Proposed solutions include positioning delicate metal inserts (not shown) within the mold to aid in supporting the tape, or modifying the mold (not shown) to clamp down on only a predetermined portion of the tape. In the former, an additional time lag is introduced into the molding cycle. In the latter, accurate tape indexing and operator monitoring would be required. Another option is to use a stronger tape, such as TapePac (trademark of National Semiconductor). However, the TapePac tape has a relatively low number of leads, and presents a restrictive sourcing requirement.

Reference is made to pages 578-591 of Microelectronics Packaging Handbook, Van Nostrand Reinhold, 1988, for a more detailed discussion of current problems with transfer molding.

Disclosure Of The Invention

It is therefore an object of the present invention to provide a process for molding IC packages that counterbalances tendencies for the die attach pad to be forced upward, thereby avoiding disorientation of the die and distortion and/or destruction of the bond wires.

It is a further object of the present invention to provide a process for molding IC packages that decreases waste and increases throughput.

It is further object of the present invention to provide a molding technique for molding bodies about tape mounted (TAB) devices, which avoids the use of metal inserts, modified mold clamping configurations, or the use of a particular tape carrier.

It is a further object of the present invention to provide a mold set for molding plastic IC packages without exerting unbalanced forces on the die attach pad and/or die.

It is further object of the present invention to provide a plastic IC package formed by the disclosed techniques.

According to the invention, a plastic-packaged semiconductor device has a die mounted to a substrate, such as a lead frame or a tape carrier. The substrate has a plurality of leads, and the die is connected, such as by bond wires, to the leads, which are supported by the peripheral portions of the mold halves.

A molded plastic body is formed about the die, and inner portions of the leads. Outer portions of the leads exit the body, for connecting the completed device to other circuits.

The body is molded in a press, by placing the mounted and connected die within a cavity created by recesses in two mold halves. Each mold set is provided with a "runner" receiving liquid molding compound from a reservoir, and at least two "gates" leading from the runner to the cavity above and below the substrate.

In the case of multiple molds, a "primary" runner receives the liquid molding compound, and "secondary" runners lead from the primary runner to at least one gate of each mold half.

In the disclosed molding process, molding compound is injected into the top and bottom mold halves, balancing forces on the top and bottom of the die-supporting substrate.

A completed, packaged semiconductor device with increased reliability is thereby created.

Other objects, features and advantages of the invention will become apparent in light of the following description thereof.

## Brief Description Of The Drawings

Figure 1A is a perspective view of a completely formed plastic-packaged semiconductor device of the prior art.

Figure 1B is a plan view, partially cutaway, of the semiconductor device of Figure 1A, at an intermediate step in the manufacture thereof, showing a lead frame.

Figure 1C is a partial cross-sectional view of a tape-mounted semiconductor device, similar in various respects to the devices shown in Figures 1A and 1B.

Figure 2A is schematic diagram of a transfer mold press of the prior art.

Figure 2B is a cross-sectional detail view of a portion of a prior art bottom mold for the transfer mold press of Figure 2A, taken on a line A-A through Figure 2A.

Figure 2C is a cross-sectional view of a prior art mold set, with semiconductor device contained within its cavity, for the transfer mold press of Figure 2A, taken on a line B-B through Figure 2A.

Figure 3 is a cross-sectional view of a mold set for molding IC packages, according to the present invention.

Figure 4 is a cross-sectional view of an alternate embodiment of a mold set, according to the present invention.

## Detailed Description Of The Invention

Figures 1A and 1B illustrate a plastic-packaged semiconductor device 100 of the prior art, and are discussed hereinabove. The techniques for creating such packages are well known, including techniques for mounting a die to a lead frame, molding a plastic body about the die and inner portions of leads,excising the lead frame, and "dejunking" (removing) superfluous plastic "flash" from between the leads.

Figure 1C illustrates a packaging technique for tape mounted semiconductor devices, and is discussed above.

Figures 2A, 2B and 2C illustrate the transfer molding process for forming bodies around semiconductor devices with a mold set, and are discussed above.

Generally, as described below, in the molding process of the present invention, each of the top and bottom mold halves are provided with gates for injecting liquid molding compound into the cavity formed by two mold halves. In this manner, forces exerted by the liquid molding compound are equalized above and below the plane of the substrate mounting the die of the semiconductor device.

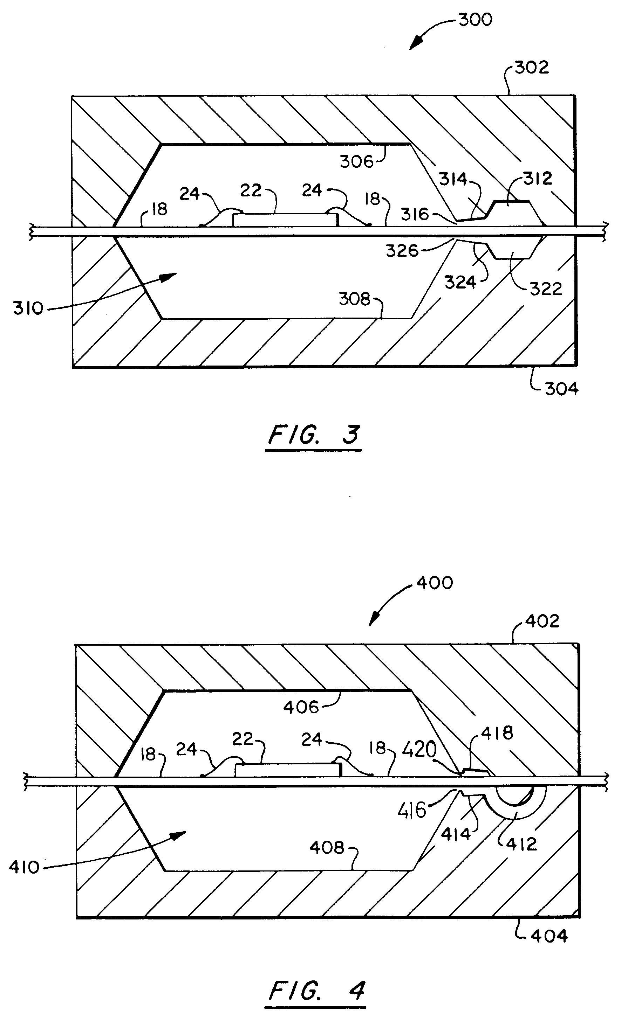

Figure 3 shows a mold set 300 for molding a body about a semiconductor device 22. The device 22 is mounted to a tape carrier (e.g., the tape layers 14 and 16 of Figure 1C), and connected with bond wires to leads 18 exiting the body, as described with respect to Figure 1C.

The mold set includes a top mold half 302 and a bottom mold half 304. The top mold half 302 is provided with a recess 306, and the bottom mold half 304 is provided with a recess 308. Together, the recesses, which face one another form a cavity 310 defining the size, shape and surface finish of the molded body (e.g., 30, Figure 1C).

The substrate-mounted semiconductor device 22 is positioned within the cavity 310, generally as shown, along a "parting line" between the two mold halves 302 and 304.

A primary runner 312 is formed in the top mold half 302, and receives liquid molding compound under pressure from a pot (shown as 214 in Figure 2A). A secondary runner 314 communicates the liquid molding compound from the primary runner 312 to the upper recess 306 of the cavity 310, via a gate 316, above the substrate 18.

Similarly, a primary runner 322 is formed in the bottom mold half 304, and receives liquid molding compound under pressure from a pot (shown as 214 in Figure 2A). A secondary runner 324 communicates the liquid molding compound from the primary runner 322 to the lower recess 308 of the cavity 310, via a gate 326, below the substrate 18.

In practice, liquid molding compound is injected via the runners and gates into the cavity, above and below the die-mounting substrate. One or more gates may be employed in each mold half, and air vents (not shown) are disposed opposite the gates to prevent partial fill of the cavity and voids in the finished part. Preferably, the primary runners 312 and 322 are lined up one above the other on the same side of the mold halves, as illustrated, but they may be otherwise disposed, such as on opposite sides of the mold halves.

Figure 4 shows an alternate embodiment for the mold set of the present invention. As in Figure 3, a semiconductor device 22 is mounted to a tape carrier (e.g., the tape layers 14 and 16 of Figure 1C), and connected with bond wires to leads 18 exiting the body, and is contained within a cavity formed by the facing recesses of the respective mold halves, which are ultimately filled with liquid molding compound to form a body about the semiconductor device.

The mold set 400 includes a top mold half 402 and a bottom mold half 404. The top mold half 402 is provided with a recess 406, and the bottom mold half 404 is provided with a recess 408. Together, the recesses, which face one another form a cavity 410 defining the size, shape and surface finish of the molded body (e.g., 30, Figure 1C).

The substrate-mounted semiconductor device 22 is positioned within the cavity 410, generally as shown, along a "parting line" defined by the faces of the two mold halves 402 and 404.

A primary runner 412 is formed in the bottom mold half 404, and receives liquid molding compound under pressure from a pot (shown as 214 in Figure 2A). A secondary runner 414 in the bottom mold half 404 communicates the liquid molding compound from the primary runner 412 to the cavity 410, via a gate 416, below the plane of the substrate 18. A secondary runner 418 in the upper mold half 402 faces the secondary runner 414, and communicates the liquid molding compound to the cavity 410, via a gate 420, above the substrate 18.

In practice, liquid molding compound is injected via the primary runner 412, secondary runners 414 and 418, and gates 416 and 420 into the cavity 410, above and below the plane of the die-mounting substrate (represented by 18). One or more gates may be employed in each mold half, although only one is shown for each half, and air vents (not shown) are disposed opposite the gates to prevent partial fill of the cavity and voids in the finished part. It should be noted that in the mold sets 300,400 the rather thin leads of the substrate 18 are positively supported by the outer peripheral rim portions of the mold halves adjacent the runners. Thus, disorientation and/or distortion of the flimsy tape structure (e.g. 14, 16, 18 in Fig.1C) during the molding process is avoided. For a save support of the substrate 18 it is clamped between the mold halves, as shown at the right and left outer portions of the mold sets 300, 400, by pressing the mold halves and the interjacent substrate together.

## Claims

1. Method of forming plastic IC packages, comprising the steps:
   - providing a mold set (300,400) including a top mold half (302,402) having a top recess (306,406) and a bottom mold half (304,404) having a bottom recess (308,408), together the top and bottom recesses (306,308;406,408) forming a cavity (310,410) for molding a body about a substrate-mounted semiconductor die (22) being connected to leads of said substrate (18);
   - providing at least one runner (312,322,412) in one of the mold halves (302,304;402,404) for receiving liquid molding compound from a reservoir;
   - providing a bottom gate (326,416) communicating the liquid molding compound from the runner (322,412) to the cavity (310,410) below the substrate (18);
   - providing a top gate (316,420) communicating the liquid molding compound from the runner (312,412) to the cavity (310,410) above the substrate (18);
   - assembling the mold set (300,400) in a press, with the substrate-mounted die (22) contained within the cavity (310,410), wherein the leads of the substrate (18) are supported by the peripheral portions of the mold halves (302,304;402,404) adjacent the runner (312,322,412); and

- providing liquid molding compound to the cavity (310,410).

2. Method according to claim 1, wherein there are provided a bottom runner (322) in the bottom mold half (304) and a top runner (312) in the top mold half (302).

3. Method according to claim 2, wherein the bottom runner (322) and the top runner (312) are arranged symmetrically as regards the plane of the substrate (18).

4. Method according to any of claims 1 to 3, wherein the semiconductor die (22) is mounted to a tape substrate (18).

5. Method according to any of claims 1 to 3, wherein the semiconductor die (22) is mounted to a lead frame substrate (18).

6. Method according to any of claims 1 to 5, wherein the molding compound is epoxy.

7. Mold set (300,400) for forming plastic IC package bodies, comprising:
   - a top mold half (302,402) having at least one gate (316,420);
   - a bottom mold half (304,404) having at least one gate (326,416); and
   - at least one runner (312,322,412) disposed in at least one of the mold halves (302,304;402,404) for communicating liquid molding compound from a reservoir to a cavity (310,410) formed by the mold halves (302,304;402,404) via the respective one of the gates (316,326;416,420) of the mold halves (302,304;402,404).

8. Mold set according to claim 7, wherein the runner (312,322,412) and the gates (316,326,416,420) are connected via secondary runners (314,324,414,418).

9. Mold set according to claim 7 or 8, wherein the cavity (310,410) of the mold halves (302,304;402,404) contains a substrate-mounted semiconductor die (22) and is surrounded by peripheral portions for supporting and clamping leads of the substrate (18).

10. Mold set according to any of claims 7 to 9, wherein injection forces on the top and bottom of the substrate (18) are balanced.

FIG. IA
PRIOR ART

FIG. IB
PRIOR ART

FIG. IC

FIG. 2A
PRIOR ART

FIG. 2B
PRIOR ART

FIG. 2C
PRIOR ART

EP 0 489 349 A1

*FIG. 3*

*FIG. 4*

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN vol. 014, no. 145 (E-090)19 March 1990 & JP-A-2 009 142 ( FUJITSU LTD. ) 12 January 1990 * abstract * | 1,2,5-10 | H01L21/56 |
| X | PATENT ABSTRACTS OF JAPAN vol. 012, no. 478 (M-775)14 December 1988 & JP-A-63 199 619 ( HITACHI LTD. ) 18 August 1988 * abstract * | 1-3,5-10 | |
| X | PATENT ABSTRACTS OF JAPAN vol. 014, no. 461 (E-098)5 October 1990 & JP-A-2 186 647 ( FUJITSU LTD. ) 20 July 1990 * abstract * | 1-3,5-10 | |
| X | PATENT ABSTRACTS OF JAPAN vol. 014, no. 467 (E-098)11 October 1990 & JP-A-2 191 365 ( MITSUBISHI ELECTRIC CORP. ) 27 July 1990 * abstract * | 1-4,6-10 | **TECHNICAL FIELDS SEARCHED (Int. Cl.5)** |
| X | PATENT ABSTRACTS OF JAPAN vol. 015, no. 026 (E-102)22 January 1991 & JP-A-2 271 648 ( MATSUSHITA ELECTRIC LTD ) 6 November 1990 * abstract * | 1-3,5-10 | H01L |
| X | PATENT ABSTRACTS OF JAPAN vol. 008, no. 174 (M-316)10 August 1984 & JP-A-59 067 031 ( HITACHI SEISAKUSHO KK ) 16 April 1984 * abstract * | 1-3,5-9 | |

The present search report has been drawn up for all claims

| Place of search | Date of completion of the search | Examiner |
|---|---|---|
| THE HAGUE | 02 APRIL 1992 | ZEISLER P.W. |

EPO FORM 1503 03.82 (P0401)